(19) Europäisches Patentamt
European Patent Office
Office européen des brevets

(11) EP 2 876 123 A1

(12) EUROPEAN PATENT APPLICATION

(43) Date of publication:
27.05.2015 Bulletin 2015/22

(21) Application number: 14194650.9

(22) Date of filing: 25.11.2014

(51) Int Cl.:
C08G 61/10 (2006.01) C08G 61/12 (2006.01)
C09D 165/02 (2006.01) C08L 65/02 (2006.01)
H01L 23/14 (2006.01) H01L 23/498 (2006.01)
H01L 23/532 (2006.01) H01B 3/30 (2006.01)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(30) Priority: 25.11.2013 US 201361908720 P

(71) Applicant: Rohm and Haas Electronic Materials LLC
Marlborough, MA 01752 (US)

(72) Inventors:
- Gilmore, Christopher D.
  Watertown, MA Massachusetts 02472 (US)
- Bu, Lujia
  Holden, MA Massachusetts 01520 (US)
- Chuang, Peng-Wei
  Natick, MA Massachusetts 01760 (US)
- Kiarie, Cecilia Waithera
  Walpole, MA Massachusetts 02081 (US)
- Kim, Young Seok
  Shrewsbury, MA Massachusetts 01545 (US)
- O'Connell, Kathleen M..
  Cumberland, RI Rhode Island (US)
- Caporale, Stephan J.
  Marlborough, MA Massachusetts 01752 (US)

(74) Representative: Houghton, Mark Phillip
Patent Outsourcing Limited
1 King Street
Bakewell, Derbyshire DE45 1DZ (GB)

(54) Dielectric materials

(57) Certain polyphenylene oligomers having good solvent strip resistance, low coefficient of thermal expansion and good adhesion to a variety of surfaces are useful as thin-film dielectric materials in electronics applications.

EP 2 876 123 A1

## Description

The present invention relates generally to the field of dielectric materials and more particularly to polyarylene oligomers for use as dielectric materials in electronics applications.

Polymer dielectrics may be used as insulating layers in various electronic devices, such as integrated circuits, multichip modules, laminated circuit boards, displays and the like. The electronics fabrication industry has different requirements for dielectric materials, such as dielectric constant, coefficient of thermal expansion, modulus, and the like, depending upon the particular application.

Various inorganic materials, such as silica, silicon nitride and alumina, have been used as dielectric materials in electronic devices. These inorganic materials generally can be deposited in thin layers, typically by vapor deposition techniques, and have advantageous properties, such as not readily absorbing water. Polymer dielectric materials often possess properties which offer advantages over inorganic dielectric materials in certain applications, such as ease of application such as by spin-coating techniques, gap-filling ability, lower dielectric constants, and the ability to withstand certain stresses without fracturing, that is, polymer dielectrics can be less brittle than inorganic dielectric materials. However, polymer dielectrics often present challenges to process integration during fabrication. For example, to replace silicon dioxide as a dielectric in certain applications such as integrated circuits, the polymer dielectric must be able to withstand processing temperatures during metallization and annealing steps of the process. In general, the polymer dielectric material should have a glass transition temperature greater than the processing temperature of subsequent manufacturing steps. Also, the polymer dielectric should not absorb water which may cause an increase in the dielectric constant and potential corrosion of metal conductors.

Polyphenylene polymers are well-known as dielectric materials. For example, U.S. Pat. No. 5,965,679 discloses certain polyphenylene oligomers prepared from a biscyclopentadienone monomer, an aromatic monomer containing three or more ethynyl moieties and optionally an aromatic monomer containing two ethynyl moieties. The polyphenylene oligomers disclosed in this patent are cross-linked due to the presence of the aromatic monomer having three or more ethynyl moieties. Dielectric layers made from these oligomers are too brittle for certain thin film applications.

J.K. Stille et al., Polymer Letters, vol. 4, pp 791-793 (1966), disclose the preparation of very high molecular weight poloyphenylene polymers from the Diels-Alder polymerization of biscyclopentadienones with diethynylbenzene. Stille et al. disclose that these polyphenylene polymer chains are terminated with a monocyclopentadienone which is present in the biscyclopentadienones in small amounts.

There remains a need for organic dielectric materials, such as poylphenylene oligomers, that have good solvent strip resistance, low coefficient of thermal expansion, and good adhesion to a variety of surfaces that are useful as thin-film dielectric materials in electronics applications.

The present invention provides an oligomer comprising as polymerized units a first monomer comprising two cyclopentadienone moieties and a second monomer having the formula (I)

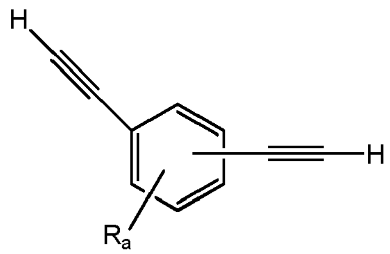

(I)

wherein a is the number of R groups and is an integer from 0 to 4; each R is independently chosen from ($C_1$-$C_4$)alkyl, halo($C_1$-$C_4$)alkyl, ($C_1$-$C_4$)alkoxy, ($C_1$-$C_4$)aralkyl, ($C_6$-$C_{10}$)aryl, or substituted ($C_6$-$C_{10}$)aryl; wherein the first monomer and the second monomer are present in a mole ratio of from 1:1.001 to 1:1.95; and wherein the oligomer comprises terminal ethynyl moieties.

Also provided by the present invention is a composition comprising the oligomer described above and an organic solvent chosen from benzyl esters of ($C_2$-$C_6$)alkanecarboxylic acids, dibenzyl esters of ($C_2$-$C_6$)alkanedicarboxylic acids, tetrahydrofurfuryl esters of ($C_2$-$C_6$)alkanecarboxylic acids, ditetrahydrofurfuryl esters of ($C_2$-$C_6$)alkanedicarboxylic acids, phenethyl esters of ($C_2$-$C_6$)alkanecarboxylic acids, diphenethyl esters of ($C_2$-$C_6$)alkanedicarboxylic acids, and aromatic ethers.

Further, the present invention provides a method of forming a dielectric material layer comprising: disposing a layer of the composition described above on a substrate surface; removing the organic solvent; and curing the oligomer to form a dielectric material layer.

Also provided by the present invention is a method of preparing a polyphenylene oligomer comprising: combining

a first monomer comprising two cyclopentadienone moieties with a second monomer having the formula (I)

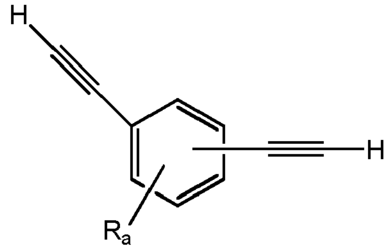

(I)

wherein a is the number of R groups and is an integer from 0 to 4; each R is independently chosen from ($C_1$-$C_4$)alkyl, halo($C_1$-$C_4$)alkyl, ($C_1$-$C_4$)alkoxy, ($C_1$-$C_4$)aralkyl, ($C_6$-$C_{10}$)aryl, or substituted ($C_6$-$C_{10}$)aryl in an organic solvent benzyl esters of ($C_2$-$C_6$)alkanecarboxylic acids, dibenzyl esters of ($C_2$-$C_6$)alkanedicarboxylic acids, tetrahydrofurfuryl esters of ($C_2$-$C_6$)alkanecarboxylic acids, ditetrahydrofurfuryl esters of ($C_2$-$C_6$)alkanedicarboxylic acids, phenethyl esters of ($C_2$-$C_6$)alkanecarboxylic acids, diphenethyl esters of ($C_2$-$C_6$)alkanedicarboxylic acids, and aromatic ethers, to form a reaction mixture; and heating the reaction mixture at a temperature of from 100 to 160 °C; wherein the first monomer and the second monomer are present in a mole ratio of from 1:1.001 to 1:1.95.

As used throughout this specification, the following abbreviations shall have the following meanings, unless the context clearly indicates otherwise: °C = degree Celsius; g = gram; mg = milligram; L = liter; Å = angstrom; nm = nanometer; μm = micron = micrometer; mm = millimeter; sec. = second; min. = minute; DI = deionized; and mL = milliliter. All amounts are percent by weight ("wt%") and all ratios are molar ratios, unless otherwise noted. All numerical ranges are inclusive and combinable in any order, except where it is clear that such numerical ranges are constrained to add up to 100%.

The articles "a", "an" and "the" refer to the singular and the plural. "Alkyl" refers to linear, branched and cyclic alkyl unless otherwise specified. "Aryl" refers to aromatic carbocycles and aromatic heterocycles. The term "oligomer" refers to dimers, trimers, tetramers and other polymeric materials that are capable of further curing. By the term "curing" is meant any process, such as polymerization or condensation, that increases the molecular weight of a material or composition. "Curable" refers to any material capable of being cured (polymerized) under certain conditions. When an element is referred to as being "disposed on" another element, it can be directly on the other element or intervening elements may be present therebetween. In contrast, when an element is referred to as being "disposed directly on" another element, there are no intervening elements present. As used herein, the term "and/or" includes any and all combinations of one or more of the associated listed items.

Oligomers of the present invention comprise as polymerized units a first monomer comprising two cyclopentadienone moieties and a second monomer having the formula (I)

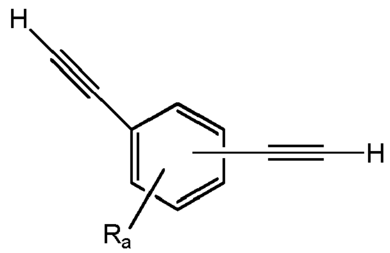

(I)

wherein a is the number of R groups and is an integer from 0 to 4; each R is independently chosen from ($C_1$-$C_4$)alkyl, halo($C_1$-$C_4$)alkyl, ($C_1$-$C_4$)alkoxy, ($C_1$-$C_4$)aralkyl, ($C_6$-$C_{10}$)aryl, or substituted ($C_6$-$C_{10}$)aryl; wherein the mole ratio of the first monomer to the second monomer is from 1:1.001 to 1:1.95; and wherein the oligomer comprises terminal ethynyl moieties. Preferably, the mole ratio of first monomer to second monomer is from 1:1.01 to 1:1.75, and more preferably from 1:1.05 to 1:1.5. The moles of second monomer are greater than the moles of first monomer used to prepare the present oligomers, with the moles of the second monomer being in a 0.1 to 95% excess as compared to the first monomer, and preferably a molar excess of from 1 to 75%. Preferably, the present oligomers are substantially free (that is, possesses < 0.5 wt%) of polymerized units of monomers having 3 or more ethynyl moieties, and more preferably do not contain (that is, are free of), as polymerized units, monomers having 3 or more ethynyl moieties. It is further preferred that the present oligomers are substantially free (that is, possesses < 0.5 wt%) of polymerized units of monomers having 3 or more cyclopentadienone moieties, and more preferably do not contain (that is, are free of), as polymerized units, monomers having 3 or more cyclopentadienone moieties. It is preferred that the oligomers are substantially free of polymerized units of monomers capable of crosslinking, that is, it is preferred that the present oligomers are linear. It is further preferred that the present oligomers have only terminal ethynyl moieties.

Any monomer containing two cyclopentadienone moieties may suitably be used as the first monomer to prepare the present oligomers. Such monomers are well-known, such as those described in U.S. Pat. Nos. 5,965,679; 6,288,188; and 6,646,081; and in Int. Pat. Pubs. WO 97/10193 and WO 2004/073824. It is preferred that the first monomer has the structure shown in formula (II)

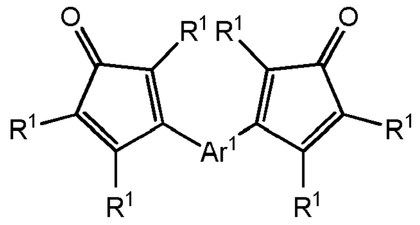
(II)

wherein each $R^1$ is independently chosen from H, $(C_1\text{-}C_6)$alkyl, phenyl, or substituted phenyl; and $Ar^1$ is an aromatic moiety. Preferably, each $R^1$ is independently chosen from $(C_3\text{-}C_6)$alkyl, phenyl and substituted phenyl, and more preferably each $R^1$ is phenyl. By "substituted phenyl" it is meant a phenyl moiety having one or more of its hydrogens replaced with one or more substituents chosen from halogen, $(C_1\text{-}C_6)$alkyl, halo$(C_1\text{-}C_6)$alkyl, $(C_1\text{-}C_6)$alkoxy, halo$(C_1\text{-}C_6)$alkoxy, phenyl, and phenoxy, and preferably from halogen, $(C_1\text{-}C_4)$alkyl, halo$(C_1\text{-}C_4)$alkyl, $(C_1\text{-}C_4)$alkoxy, halo$(C_1\text{-}C_4)$alkoxy, and phenyl. It is preferred that substituted phenyl is a phenyl moiety having one or more of its hydrogens replaced with one or more substituents chosen from halogen, $(C_1\text{-}C_6)$alkyl, $(C_1\text{-}C_6)$alkoxy, phenyl, and phenoxy. Preferably, a substituted phenyl has from 1 to 3 substituents, and more preferably 1 or 2 substituents. A wide variety of aromatic moieties are suitable for use as $Ar^1$, such as those disclosed in U.S. Pat. No. 5,965,679. Exemplary aromatic moieties useful for $Ar^1$ include those having the structure shown in formula (III)

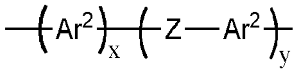
(III)

wherein x is an integer chosen from 1, 2 or 3; y is an integer chosen from 0, 1, or 2; each $Ar^2$ is independently chosen from

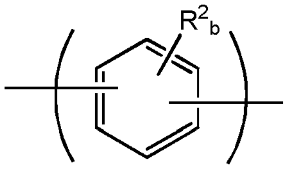
(IV) or
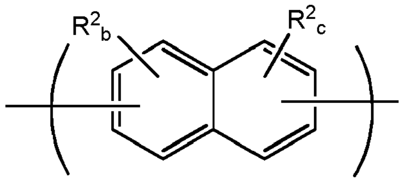
(V);

each $R^2$ is independently chosen from halogen, $(C_1\text{-}C_6)$alkyl, halo$(C_1\text{-}C_6)$alkyl, $(C_1\text{-}C_6)$alkoxy, halo$(C_1\text{-}C_6)$alkoxy, phenyl, and phenoxy; b is an integer from 0 to 4; c is an integer from 0 to 4; each Z is independently chosen from O, S, $NR^3$, $PR^3$, $P(=O)R^3$, C(=O), $CR^4R^5$, and $SiR^4R^5$; $R^3$, $R^4$, and $R^5$ are independently chosen from H, $(C_1\text{-}C_4)$alkyl, halo$(C_1\text{-}C_4)$alkyl, and phenyl. It is preferred that x is 1 or 2, and more preferably 1. It is preferred that y is 0 or 1, and more preferably 1. Preferably, each $R^2$ is independently chosen from halogen, $(C_1\text{-}C_4)$alkyl, halo$(C_1\text{-}C_4)$alkyl, $(C_1\text{-}C_4)$alkoxy, halo$(C_1\text{-}C_4)$alkoxy, and phenyl, and more preferably from fluoro, $(C_1\text{-}C_4)$alkyl, fluoro$(C_1\text{-}C_4)$alkyl, $(C_1\text{-}C_4)$alkoxy, fluoro$(C_1\text{-}C_4)$alkoxy, and phenyl. It is preferred that b is from 0 to 3, more preferably from 0 to 2, and yet more preferably 0 or 1. It is preferred that c is from 0 to 3, more preferably from 0 to 2, and yet more preferably 0 or 1. In formula (V), it is preferred that b + c = 0 to 4, and more preferably 0 to 2. Each Z is preferably independently chosen from O, S, $NR^3$, C(=O), $CR^4R^5$, and $SiR^4R^5$, more preferably from O, S, C(=O), and $CR^4R^5$, and yet more preferably from O, C(=O), and $CR^4R^5$. It is preferred that each $R^3$, $R^4$, and $R^5$ are independently chosen from H, $(C_1\text{-}C_4)$alkyl, fluoro$(C_1\text{-}C_4)$alkyl, and phenyl; and more preferably from H, $(C_1\text{-}C_4)$alkyl, fluoro$(C_1\text{-}C_2)$alkyl, and phenyl. Preferably, each $Ar^2$ has the structure (IV).

The second monomer useful in preparing the present oligomers has the formula (I)

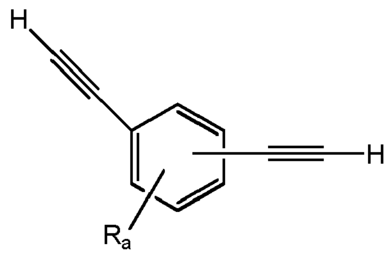

(I)

wherein a is the number of R groups and is an integer from 0 to 4; each R is independently chosen from ($C_1$-$C_4$)alkyl, halo($C_1$-$C_4$)alkyl, ($C_1$-$C_4$)alkoxy, ($C_1$-$C_4$)aralkyl, ($C_6$-$C_{10}$)aryl, or substituted ($C_6$-$C_{10}$)aryl. Preferably, a is from 0 to 3, more preferably from 0 to 2, and yet more preferably a is 0. It is preferred that each R is independently chosen from ($C_1$-$C_4$)alkyl, fluoro($C_1$-$C_4$)alkyl, ($C_1$-$C_4$)alkoxy, benzyl, phenethyl, phenyl, naphthyl, substituted phenyl and substituted naphthyl, more preferably ($C_1$-$C_2$)alkyl, fluoro($C_1$-$C_4$)alkyl, ($C_1$-$C_2$)alkoxy, phenyl, and substituted phenyl, and yet more preferably from ($C_1$-$C_2$)alkyl, fluoro($C_1$-$C_4$)alkyl, ($C_1$-$C_2$)alkoxy, and phenyl. "Substituted ($C_6$-$C_{10}$)aryl" refers to any ($C_6$-$C_{10}$)aryl moiety having one or more of its hydrogens replaced with one or more substituents chosen from halogen, ($C_1$-$C_4$)alkyl, halo($C_1$-$C_4$)alkyl, ($C_1$-$C_4$)alkoxy, halo($C_1$-$C_4$)alkoxy, and phenyl, and preferably from ($C_1$-$C_3$)alkyl, halo($C_1$-$C_4$)alkyl, ($C_1$-$C_3$)alkoxy, fluoro($C_1$-$C_4$)alkoxy, and phenyl. Fluorine is a preferred halogen. The second monomer comprises 2 ethynyl moieties, each having a terminal hydrogen. The 2 ethynyl moieties may have a meta or para relationship to each other. Preferably, the ethynyl moieties do not have an ortho relationship to each other.

The oligomers of the present invention are prepared by reacting one or more first monomers with one or more second monomers in a suitable organic solvent. The mole ratio of the total first monomers to the total second monomers is from 1:1.001 to 1:1.95, preferably from 1:1.01 to 1:1.75, and more preferably from 1:1.05 to 1:1.5. The total moles of second monomers used are greater than the total moles of first monomers used. Suitable organic solvents useful to prepare the present oligomers are benzyl esters of ($C_2$-$C_6$)alkanecarboxylic acids, dibenzyl esters of ($C_2$-$C_6$)alkanedicarboxylic acids, tetrahydrofurfuryl esters of ($C_2$-$C_6$)alkanecarboxylic acids, ditetrahydrofurfuryl esters of ($C_2$-$C_6$)alkanedicarboxylic acids, phenethyl esters of ($C_2$-$C_6$)alkanecarboxylic acids, diphenethyl esters of ($C_2$-$C_6$)alkanedicarboxylic acids, and aromatic ethers. Preferred aromatic ethers are diphenyl ether, dibenzyl ether, ($C_1$-$C_6$)alkoxy-substituted benzenes and benzyl ($C_1$-$C_6$)alkyl ethers, and more preferably ($C_1$-$C_4$)alkoxy-substituted benzenes and benzyl ($C_1$-$C_4$)alkyl ethers. Preferred organic solvents are benzyl esters of ($C_2$-$C_4$)alkanecarboxylic acids, dibenzyl esters of ($C_2$-$C_4$)alkanedicarboxylic acids, tetrahydrofurfuryl esters of ($C_2$-$C_4$)alkanecarboxylic acids, ditetrahydrofurfuryl esters of ($C_2$-$C_4$)alkanedicarboxylic acids, phenethyl esters of ($C_2$-$C_4$)alkanecarboxylic acids, diphenethyl esters of ($C_2$-$C_4$)alkanedicarboxylic acids, ($C_1$-$C_6$)alkoxy-substituted benzenes, and benzyl ($C_1$-$C_6$)alkyl ethers, more preferably benzyl esters of ($C_2$-$C_6$)alkanecarboxylic acids, tetrahydrofurfuryl esters of ($C_2$-$C_6$)alkanecarboxylic acids, phenethyl esters of ($C_2$-$C_6$)alkanecarboxylic acids, ($C_1$-$C_4$)alkoxy-substituted benzenes, benzyl ($C_1$-$C_4$)alkyl ethers, and dibenzyl ether, and yet more preferably benzyl esters of ($C_2$-$C_6$)alkanecarboxylic acids, tetrahydrofurfuryl esters of ($C_2$-$C_6$)alkanecarboxylic acids, ($C_1$-$C_4$)alkoxy-substituted benzenes, and benzyl ($C_1$-$C_4$)alkyl ethers. Exemplary organic solvents include, without limitation, benzyl acetate, benzyl proprionate, tetrahydrofurfuryl acetate, tetrahydrofurfuryl propionate, tetrahydrofurfuryl butyrate, anisole, methylanisole, dimethylanisole, dimethoxybenzene, ethylanisole, ethoxybenzene, benzyl methyl ether, and benzyl ethyl ether, and preferably benzyl acetate, benzyl proprionate, tetrahydrofurfuryl acetate, tetrahydrofurfuryl propionate, tetrahydrofurfuryl butyrate, anisole, methylanisole, dimethylanisole, dimethoxybenzene, ethylanisole, and ethoxybenzene.

The oligomers of the present invention may be prepared by combining the first monomer, the second monomer and organic solvent, each as described above, in any order in a vessel, and heating the mixture. The first monomer may first be combined with the organic solvent in a vessel, and the second monomer then added to the mixture. In one embodiment, the first monomer and organic solvent mixture is first heated to the desired reaction temperature before the second monomer is added. The second monomer may be added at one time, but is preferably added over a period of time, such as from 0.25 to 46 hours, and preferably from 1 to 6 hours, to reduce exotherm formation. The first monomer and organic solvent mixture may first be heated to the desired reaction temperature before the second monomer is added. Alternatively, the first monomer, second monomer and solvent are added to a vessel, and then heated to the desired reaction temperature and held at this temperature for a period of time to provide the desired oligomer. The reaction mixture is heated at a temperature of 100 to 160 °C. Preferably, the mixture is heated to a temperature of 110 to 160 °C, more preferably 110 to 155 °C, and yet more preferably 110 to 145 °C. The reaction may be carried out under oxygen-containing atmosphere, but an inert atmosphere is preferred. Following the reaction, the resulting oligomer may be isolated from the reaction mixture or used as is for coating a surface.

The oligomer of the present invention typically has a weight average molecular weight ($M_w$) in the range of 5000 to 80000, preferably from 5000 to 50000, more preferably from 5000 to 40000, and yet more preferably from 5000

to 30000. A particularly preferred $M_w$ range is from 7500 to 30000, and an even more preferred range is from 7500 to 28000. The choice of organic solvent can be used to tailor the $M_w$ of the resulting oligomer. For example, when aromatic ether solvents, such as $(C_1-C_6)$alkoxy-substituted benzenes, are used, relatively high Mw oligomers, such as about 75000 to 80000, may be obtained after 6 hours of reaction time at 160 °C, as compared to oligomers having a $M_w$ of about 30000 when the same reaction is performed using a benzyl ester of a $(C_2-C_6)$alkanecarboxylic acid as the organic solvent. The molecular weight of the oligomer can also be controlled, even in aromatic ether solvents, by adjusting the amount of the second monomer. For example, to obtain an oligomer having a $M_w$ of ≤ 35000, > 1.05 mole of the second monomer should be used for each 1 mole of the first monomer, that is, the mole ratio of first monomer to second monomer should be ≥ 1:1.05, such as from 1:1.075 to 1:1.95. Unexpectedly, the use of the organic solvents described above, particularly at reaction temperatures of ≤ 160 °C, provides a more controllable method of preparing polyphenylene oligomers having lower $M_w$ (such as ≤ 35000, and preferably ≤ 25000) than oligomers prepared conventional methods, such as that disclosed in U.S. Pat. No. 5,965,679.

While not intending to be bound by theory, it is believed that the present polyphenylene oligomers are formed through the Diels-Alder reaction of the cyclopentadienone moieties of the first monomer with the ethynyl moieties of the second monomer groups upon heating. During such Diels-Alder reaction, a carbonyl-bridged species forms. It will be appreciated by those skilled in the art that such carbonyl-bridged species may be present in the oligomers. Upon further heating, the carbonyl bridging species will be essentially fully converted to an aromatic ring system. Due to the mole ratio of the monomers used, these oligomers contain ethynyl end (terminal) moieties. Again, not wishing to be bound by theory, it is believed that no unreacted cyclopentadienone moieties remain in the present oligomers.

The present oligomer in the organic reaction solvent can be directly cast as a film, applied as a coating or poured into a non-solvent to precipitate the oligomer or polymer. Water, methanol, ethanol and other similar polar liquids such as glycol ethers are typical non-solvents which can be used to precipitate the oligomer. Solid oligomer may be dissolved and processed from a suitable organic solvent described above. More commonly, the oligomer is processed directly from the reaction solution and the advantages of the present invention are more fully realized in that instance. Since the oligomer is soluble in the organic solvent used as the reaction medium, the organic solution of the oligomer can be cast or applied and the solvent evaporated. It will be appreciated by those skilled in the art that the concentration of the oligomer in the organic reaction solvent may be adjusted by removing a portion of the organic solvent, or by adding more of the organic solvent, as may be desired.

In use, the composition comprising the present oligomer and organic solvent may be disposed by any suitable method on any suitable substrate surface. Suitable methods for disposing the composition include, but are not limited to, spin-coating, curtain coating, spray coating, roller coating, dip coating, and vapor deposition, among other methods. In the electronics manufacturing industry, spin-coating is a preferred method to take advantage of existing equipment and processes. In spin-coating, the solids content of the composition may be adjusted, along with the spin speed, to achieve a desired thickness of the composition on the surface it is applied to. Typically, the present compositions are spin-coated at a spin speed of 400 to 4000 rpm. The amount of the composition dispensed on the wafer or substrate depends on the total solids content in the composition, the desired thickness of the resulting coating layer, and other factors well-known to those skilled in the art.

When the present oligomer compositions are used to deposit a coating or film using certain techniques, such as spin-coating, the resulting coating may suffer from certain defects. While not wishing to be bound by theory, it is believed that such defects result from the condensation of moisture on the film surface due to evaporative cooling, and such moisture forces the oligomer out of solution, resulting in a non-uniform coating of oligomer on the surface. To address such defects, a secondary solvent, which is both water-miscible and miscible with the organic solvent used in the composition, may optionally be added to the present oligomer composition. It is believed that such secondary solvent prevents the formation of water droplets during deposition of the oligomer coating on the substrate. Such secondary solvent may be added to the present composition in any suitable amount, such as from 0 to 40 wt%, based upon the total weight of the composition, and preferably from 0 to 30 wt%. Ethyl lactate and gamma-butyrolactone are examples of such a secondary solvent.

In general, the present compositions comprise a polyphenylene oligomer, an organic solvent, and an optional secondary solvent, each as described above, wherein the oligomer is present in an amount of 1 to 35% solids, and preferably from 5 to 15% solids. Such compositions can be used to deposit an oligomer coating on a substrate, where the oligomer coating layer has a thickness of from 50 nm to 500 μm, preferably from 100 nm to 250 μm, and more preferably from 100 nm to 100 μm.

Preferably, after being disposed on a substrate surface, the oligomer composition is heated (soft baked) to remove any organic solvent present. Typical baking temperatures are from 90 to 140 °C, although other suitable temperatures may be used. Such baking to remove residual solvent is typically done for approximately 30 seconds to 2 minutes, although longer or shorter times may suitably be used. Following solvent removal, a layer, film or coating of the oligomer on the substrate surface is obtained. Preferably, the oligomer is next cured, such as by heating to at a temperature of ≥ 300 °C, preferably ≥ 350 °C, and more preferably ≥ 400 °C. Such curing step may take from 2 to 180

min., preferably from 10 to 120 min., and more preferably from 15 to 60 min., although other suitable times may be used. In one embodiment, a belt furnace may be used to cure the oligomer layer on a substrate. Such curing step may be performed in an oxygen-containing atmosphere, or in an inert atmosphere, and preferably in an inert atmosphere.

Upon curing, it is believed that the present oligomers further polymerize. As the present compositions contain linear oligomers and do not contain crosslinkers, such curing can only increase the chain length of the linear materials. Such cured, linear polyphenylene materials possess surprising properties. The variation in film thickness between a 500 nm thick uncured and cured film of the present oligomers is ≤ 5%, and preferably ≤ 3%, as measured on a 200 mm semiconductor wafer using a $T_{HERMAWAVE}$™ ellipsometer. Cured films of the present oligomers show a weight loss of ≤ 0.3% after 60 minutes at 450 °C as determined by thermogravimetric analysis, compared to a weight loss of > 1.7% for conventional crosslinked polyphenylene materials under the same conditions. The coefficient of thermal expansion (CTE) of cured films of the present oligomers can be tailored by selecting the appropriate $M_w$ of the oligomer used. For example, oligomers having a $M_w$ in the range of 20000 to 46000 produce cured polyphenylene films having a CTE of 35 to 40 ppm/°C, and cured films produced from oligomers having a $M_w$ of 57000 have a CTE of 70 ppm/°C. In contrast, conventional cured crosslinked polyphenylene films produced from crosslinkable oligomers having a $M_w$ of 15000 have a CTE of about 65 ppm/°C. Cured polyphenylene films of the present oligomers show greatly reduced film thickness loss (that is, better solvent strip resistance) upon contact with anisole as compared to cured polyphenylene films of oligomers having terminal cyclopentadienone moieties. For example, cured polyphenylene films formed from the present oligomers having a $M_w$ in the range of 23000 to 75000 lost < 3% of film thickness, whereas a cured polyphenylene film formed from an oligomer having terminal cyclopentadienone moieties and a $M_w$ of 27000 lost 96% of thickness under the same conditions. Cured films formed from the present oligomers are much less brittle (that is, more flexible) as compared to cured conventional polyphenylene films.

Conventional cured, crosslinked polyphenylene films do not have good adhesion to substrate surfaces and require the use of an adhesion promoter, such as described in U.S. Pat. No. 5,668,210. Such adhesion promoter is typically applied to the substrate surface before the deposition of a layer conventional polyphenylene oligomers, which is then cured to form the crosslinked film. Surprisingly, cured films of the present oligomers also have good adhesion to substrate surfaces, such as silica, silicon nitride, FR-4, and the like, without the need to use a separate adhesion promoter. However, such an adhesion promoter may optionally be used, but is not required. If it is desired to use an adhesion promoter, any conventional adhesion promoter for polyphenylene films may be used, such as silanes, preferably organosilanes such as trimethoxyvinylsilane, triethoxyvinylsilane, hexamethyldisilazane $[(CH_3)_3\text{--}Si\text{--}NH\text{--}Si(CH_3)_3]$, or an aminosilane coupler such as gamma-aminopropyltriethoxysilane, or a chelate such as aluminum monoethylacetoacetatedi-isopropylate $[((i\text{-}C_3H_7O)_2Al(OCOC_2H_5CHCOCH_3))]$. In some cases, the adhesion promoter is applied from 0.01 weight percent to 5 weight percent solution, excess solution is removed, and then the polyphenylene oligomer applied. In other cases, for example, a chelate of aluminum monoethylacetoacetatedi-isopropylate, can be incorporated onto a substrate by spreading a toluene solution of the chelate on a substrate and then baking the coated substrate at 350 °C for 30 minutes in air to form a very thin (for example 5 nm) adhesion promoting layer of aluminum oxide on the surface. Other means for depositing aluminum oxide are likewise suitable. Alternatively, the adhesion promoter, in an amount of, for example, from 0.05 to 5 wt% based on the weight of the monomer, can be blended with the monomer before polymerization, negating the need for formation of an additional layer. Particularly suitable adhesion promoters include AP 3000, AP 8000, and AP 9000S, available from Dow Electronic Materials (Marlborough, Massachusetts).

The oligomers of the present invention are particularly useful in forming a relatively low dielectric constant insulating polyphenylene material on an electronic device substrate, such as in integrated circuits, circuit packaging applications, multichip modules, circuit boards, or displays. Cured polyphenylene dielectric material produced according to the present invention may be used as is or may be combined with one or more additional dielectric materials, which may be organic or inorganic, to provide the desired insulation layer. Accordingly, the oligomers of the present invention may be used to deposit a coating on a variety of electronic device substrates, including, without limitation, FR-4, silica, silicon nitride, silicon oxynitride, silicon carbide, silicon-germanium, gallium-arsenide, indium-phosphide, aluminum nitride, alumina, and the like.

Example 1: The general procedure for preparing the oligomers of the invention is illustrated by the following scheme and description.

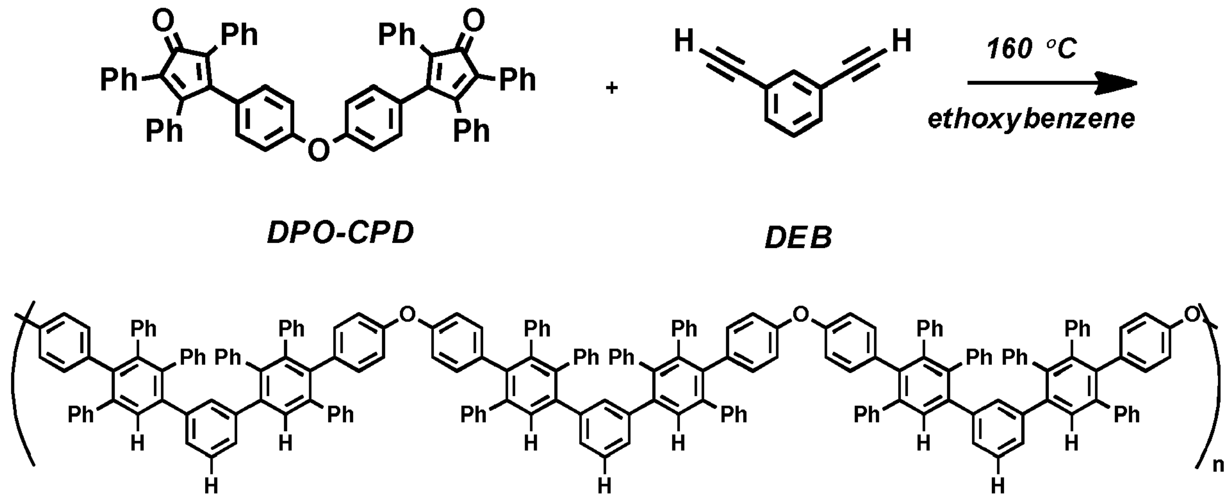


DPO-CPD DEB

To a multi-neck round-bottomed flask containing a stir bar, diphenylene oxide bis(triphenylcyclopentadienone) (DPO-CPD, 10.95 g, 13.98 mmol) was added via powder funnel, followed by the reaction solvent, ethoxybenzene (33 mL, 40% reagent weight by solvent volume). The reaction was stirred gently at room temperature. The flask was next equipped with a reflux condenser and an internal thermocouple probe attached to a self-regulating thermostat control for a heating mantle, and placed under a nitrogen atmosphere. At this point, 1,3-diethynylbenzene (DEB, 2.0 mL, 15.38 mmol) was added via syringe. The dark maroon contents of the flask were warmed to an internal temperature of 160 °C over the course of 30 minutes and maintained at this temperature for 2 hours before cooling to room temperature by removal of the heating element. At this point, 33 mL of ethoxybenzene were added to the solution, and the vessel was further cooled to room temperature, providing a clear, pale orange solution. The $M_w$ of the oligomer was 30000, as determined by GPC using polystyrene standards.

<u>Example 2.</u> To a 1 L OptiMax reactor (glass lined, with TEFLON™ fluoropolymer drainage plug), were added 109.42 g of DPO-CPD (1.0 equiv) and 19.4 g of DEB (1.1 equiv) before 309 g ethoxybenzene solvent (40% reagent weight by solvent volume) wa added to form a deep maroon heterogeneous mixture. The reactor was transferred to the Optimax instrument and sealed under an atmosphere of nitrogen gas. To the reactor top were affixed a stirring rod with a 4-paddle stirrer (elevated to 1 cm from the reactor bottom), a water-cooled reflux condenser, an internal thermocouple (placed at the median depth of the mixture, radially disposed halfway between the stirring shaft and the reactor wall), and a 1 cm baffle (placed perpendicular and adjacent to the outer wall of the reactor). The reactor was set to an internal temperature of 25 °C and stirring was initiated at 100 rpm to mix the heterogeneous contents. After a 10 minute equilibration period at 25 °C, the reactor was warmed at a rate of 2 °C per minute until reaching an internal temperature of 160 °C. Upon reaching 160 °C, the reactor temperature was maintained at 160 °C for a period of 2 hours. After the 2 hour isothermal step, the reactor was cooled from 160 °C to 25 °C at a rate of 2 °C/minute. Once cooled to 25 °C, the contents of the reactor were transferred through the outlet at the bottom of the reactor to a waiting 450 mL bottle. Residual oligomer solution was removed from the stirring rod by accelerating the rotation to 1000 rpm. The total collection time was approximately 10 minutes while gravitational flow enabled removal of most of the solution. The solids content of the resulting mixture was 30 ± 0.5%, and the measured viscosity was 445 ± 20 cst. The resulting oligomer had a $M_w$ of approximately 22500. Oligomer yield, based on solid content, was 99%. Residual monomer analysis by GPC and LC/MS showed that no unreacted DPO-CPD or DEB starting material remained in the solution upon completion of the reaction.

<u>Example 3.</u> The general procedure of Example 1 was repeated using the mole ratio of the DPO-CPD and DEB monomers, solvent, reaction temperature and reaction time reported in Table 1. The $M_w$ of the resulting oligomer is also reported in Table 1.

Table 1

| Sample | $M_w$ | DPO-CPR: DEB Mole Ratio | Solvent | Time (hours) | Temp (°C) |
|---|---|---|---|---|---|
| 3-1 | 33700 | 1:1.05 | Benzyl propionate | 23.5 | 140 |
| 3-2 | 10500 | 1:1.05 | " | 7 | 130 |
| 3-3 | 11000 | 1:1.1 | " | 24 | 160 |
| 3-4 | 23000 | 1:1.05 | Benzyl propionate | 24 | 160 |
| 3-5 | 9000 | 1:1.5 | Gamma butyrolactone | 24 | 154 |

(continued)

| Sample | $M_w$ | DPO-CPR: DEB Mole Ratio | Solvent | Time (hours) | Temp (°C) |
|---|---|---|---|---|---|
| 3-6 | 21000 | 1:1.01 | Anisole | 16 | 150 |
| 3-7 | 103000 | 1:1.01 | " | 20 | 154 |
| 3-8 | 26000 | 1:1.05 | " | 6 | 154 |
| 3-9 | 22000 | 1:1.1 | Anisole | 3.25 | 154 |
| 3-10 | 55000 | 1:1.01 | Ethoxybenzene | 6 | 160 |
| 3-11 | 36000 | 1:1.05 | Ethoxybenzene | 6 | 160 |
| 3-12 | 22500 | 1:1.1 | Ethoxybenzene | 6 | 160 |

Example 4. The procedure of Example 1 is repeated except the monomers and solvents used are replaced by those in Table 2. The mole ratio of the first monomer to second monomer is also reported in Table 2.

Table 2

| First Monomer | Second Monomer | Monomer Mole Ratio | Solvent |
|---|---|---|---|
| DPO-CPD | DEMB | 1:1.07 | A |
| DP-CPD | DEMB | 1:1.03 | A |
| DP-CPD | DEMeOB | 1:1.12 | B |
| DPO-CPD | DEBP | 1:1.2 | C |
| PFPDP-CPD | DEBP | 1:1.05 | B |
| N-CPD | DEMBP | 1:1.1 | D |
| DP-CPD | DEMeOBP | 1:1.15 | E |
| P-CPD | p-DEB | 1:1.08 | A |
| N-CPD | p-DEB | 1:1.05 | B |
| TP-CPD | DEMeOBP | 1:1.25 | F |

The following abbreviations are used in Table 2: DP-CPD = diphenylene bis(triphenylcyclopentadienone); P-CPD = phenylene bis(triphenylcyclopentadienone); TP-CPD = triphenylene bis(triphenylcyclopentadienone); N-CPD = naphthylene bis(triphenylcyclopentadienone); PFPDP-CPD = perfluoropropyl-2,2-diphenylene bis(triphenylcyclopentadienone); DEMB = 1,3-diethynyl-5-methylbenzene; DEMeOB = 1,3-diethynyl-5-methoxylbenzene; DEBP = 3,5-diethynyl-1,1'-biphenyl; DEMBP = 3,5-diethynyl-4'methyl-1,1'-biphenyl; DEMeOBP = 3,5-diethynyl-4'methoxy-1,1'-biphenyl; and p-DEB = 1,4-diethylbenzene. The solvents used are: A = anisole; B = benzyl propionate; C = ethoxybenzene; D = 1,3-dimethoxybenzene; E = 1,4-methylanisole; and F = 1,4-propylanisole.

Example 5. A sample of an oligomer prepared by the general procedure of Example 1, but having an $M_w$ of 23000, in ethoxybenzene was used to deposit a film of the oligomer on a 200 mm semiconductor wafer by spin-coating using a spin speed of 1000 rpm for 90 sec., followed by baking at 110 °C for 60 sec. to remove any residual solvent. Visual inspection of the coated wafer showed the formation of a large white spot having a tail oriented toward the wafer's center. Next, 25 wt% of ethyl lactate was added to the oligomer sample (solvent weight ratio of 3:1 ethoxybenzene:ethyl lactate) and this co-solvent containing sample was used to deposit a film of the oligomer using the same wafer coating conditions. The introduction of ethyl lactate (a polar, protic, water-miscible solvent) as a co-solvent completely eliminated the white spot defect and a defect-free smooth coating of the oligomer was obtained.

Example 6. A sample of an oligomer prepared by the general procedure of Example 1, but having an $M_w$ of 20000, in ethoxybenzene was used to deposit a film of the oligomer on a 200 mm semiconductor wafer by spin-coating using a spin speed of 1000 rpm for 90 sec., followed by baking at 110 °C for 60 sec. to remove any residual solvent. A film thickness map was acquired using a Thermawave™ ellipsometer, with the average film thickness being 5064 $\pm$ 8 Å. The observed thickness variation across the wafer was within 25 Å. Next, the oligomer film was cured in a belt furnace under $N_2$ using the following programmed temperature sequence: 250 °C - 300 °C - 400 °C (4 zones) - 300 °C - 250 °C, with 7.5 min for each zone. A film thickness map of the cured film was acquired using the Thermawave™ ellipsometer,

with the average film thickness being 4953 ± 9 Å. This is a film thickness loss of only 2.2% after curing.

Example 7. A sample of an oligomer prepared by the general procedure of Example 1, but having an $M_w$ of 23000, in ethoxybenzene was used to deposit a film of the oligomer on a 200 mm semiconductor wafer by spin-coating using a spin speed of 1000 rpm for 90 sec., followed by baking at 110 °C for 60 sec. to remove any residual solvent. Next, the oligomer film was cured in a belt furnace under $N_2$ using the following programmed temperature sequence: 250 °C - 300 °C - 400 °C (4 zones) - 300 °C - 250 °C, with 7.5 min for each zone. The cured coating was then heated at 450 °C for 1 hr and monitored for weight loss by thermogravimetric analysis (TGA). The cured coating formed from an oligomer of the invention were quite stable under these conditions, losing only 0.28% of its weight during the 60 minute isothermal hold at 450 °C. Comparatively, a conventional crosslinked polyphenylene coating, prepared from a crosslinkable oligomer having a $M_w$ of approximately 19000, showed a 1.72% weight loss under the same conditions.

Example 8. The solvent stripping resistance of various films formed from oligomers of the invention was compared to polyphenylene films formed from comparative monomers. Three oligomers of the invention were prepared by the general procedure of Example 1, having Mw values of 23000, 57000 and 75000 (Samples 8-1, 8-2, and 8-3, respectively). Samples 8-1, 8-2 and 8-3 contained ethoxybenzene as the solvent. Comparative samples C-1 and C-2 were conventional polyphenylene oligomers and prepared according to the general procedure of Example 1, except that the mole ratio of DPO-CPD:DEB was 1:1, and the solvent was anisole. Comparative samples C-1 and C-2 were determined to have Mw values of 169000 and 32000, respectively. Comparative sample C-3, another conventional polyphenylene oligomer, was also prepared according to the general procedure of Example 1, except that anisole was the solvent and the mole ratio of DPO-CPD:DEB was 1.1:1, meaning that Comparative sample C-3 had terminal cyclopentadienone moieties.

Films of each oligomer sample were formed on a 200 mm semiconductor wafer by spin-coating using a spin speed of 1000 rpm for 90 sec., followed by baking at 110 °C for 60 sec. to remove any residual solvent. Next, each oligomer film was cured in a belt furnace under $N_2$ using the following programmed temperature sequence: 250 °C - 300 °C - 400 °C (4 zones)-300 °C - 250 °C, with 7.5 min for each zone. The thickness of each cured film was measured. Either anisole or propyleneglycol methyl ether acetate (PGMEA) was puddle on the cured film for 60 seconds at room temperature, after which time each film was and spin dried, and then subjected to a soft bake step at 170 °C for an additional 60 seconds. After this baking step, the thickness of each film was again measured. All cured films were resistant to PGMEA, showing essentially no loss of film thickness upon contact with PGMEA. Film thickness loss of each of the films upon contact with anisole is reported in Table 3. As can be seen from the data, cured films prepared from the oligomers of the invention showed very low film thickness loss (≤ 10%) upon contact with anisole, with samples 8-1 and 8-2 showing < 1% thickness loss. In contrast, Comparative samples C-1, C-2 and C-3 each showed ≥ 25% thickness loss upon contact with anisole. These data clearly show that cured films of the present oligomers are significantly more resistant to stripping by solvent contact as compared with cured films of conventional polyphenylene oligomers.

Table 3

| Sample | $M_w$ | Film Thickness Loss (%) |
|---|---|---|
| 8-1 | 23000 | 0.5 |
| 8-2 | 57000 | 0 |
| 8-3 | 75000 | 2.6 |
| | | |
| C-1 | 169000 | 25 |
| C-2 | 32000 | 75.8 |
| C-3 | 27000 | 97 |

Example 9. The adhesion of cured films formed from the present oligomers to a silicon wafer was evaluated using a conventional cross-hatch test. Sample A (Comparative) was a conventional polyphenylene oligomers having an $M_w$ of approximately 19000 and prepared according to the general procedure of Example 1, except that the mole ratio of DPO-CPD:DEB was 1:1. Sample D was an oligomer of the invention prepared according to the general procedure of Example 1 and having an $M_w$ of 23000. Sample B was a 3:1 by weight mixture of the oligomers of Sample A and Sample D, respectively. Sample C was a 1:3 by weight mixture of the oligomers of Sample A and Sample D, respectively. Films of each of Samples A to D were formed on 200 mm semiconductor wafers by spin-coating using a spin speed of 1000 rpm for 90 sec., followed by baking at 110 °C for 60 sec. to remove any residual solvent. Next, each oligomer film was cured in a belt furnace under $N_2$ using the following programmed temperature sequence: 250 °C - 300 °C - 400 °C (4 zones) - 300 °C - 250 °C, with 7.5 min for each zone.

A lattice pattern test area was cut into each cured oligomer film using a cross-hatch cutter. Any loose film particles were then removed from the lattice patterned test area. SCOTCH™ brand 600 tape (available from 3M, Minneapolis, Minnesota) was then firmly applied over each lattice pattern and removed quickly by pulling the tape back off of the test area to reveal the amount of film removed by the tape. Each test area was then visually compared to ASTM standards D3002 and D3359, where a rating of 5 indicates no loss of film and a rating of 0 indicates extensive film loss. The ratings of each of the cured films is shown in Table 4.

Table 4

| Oligomer used to Form Cured Film | Rating |
|---|---|
| Sample A | 0 |
| Sample B | 3 |
| Sample C | 5 |
| Sample D | 5 |

These data clearly show that cured films formed from the oligomer of the invention (Sample D) have excellent adhesion to the substrate surface without then need to use an adhesion promoter, whereas cured films formed from conventional polyphenylene oligomers (Sample A) have poor adhesion to the substrate surface when no adhesion promoter is used. Also, the data for samples B and C clearly indicate that the adhesion of cured conventional polyphenylene films can be greatly improved by incorporating an amount of the present oligomer into a conventional polyphenylene oligomer.

Example 10. Comparative sample C-4, a conventional polyphenylene oligomer, was prepared according to the general procedure of Example 1, except that the mole ratio of DPO-CPD:DEB was 1:1. Samples 10-1 to 10-4 were also prepared according to the general procedure of Example 1. The $M_w$ of each of samples C-4 and 10-1 to 10-4 are reported in Table 4 below.

Films of each of samples C-4 and 10-2 were spin-coated (1000 rpm, 90 sec.) on a 200 mm silicon wafer, baked at 110 °C, and then cured in a belt furnace under $N_2$ using the following programmed temperature sequence: 250 °C - 300 °C - 400 °C (4 zones) - 300 °C - 250 °C, with 7.5 min for each zone. Each of the cured samples was cut into approximate 1 $cm^2$ pieces, and mounted in an aluminum sample puck for modulus testing. Nanoindentation measurements were collected at 10% tip penetration using a Nano Indenter G200 (Agilent Technologies). The Continuous Stiffness Measurement (CSM) technique with Oliver-Pharr analysis (W.C. Oliver et al., "Measurement of Hardness and Elastic Modulus by Instrumented indentation: Advances in Understanding and Refinements to Methodology," Journal of Materials Research, 19 (2004)) was used for measuring both the elastic modulus and hardness of each film sample. The results for the substrate independent measurements were determined using the Hay-Crawford model (J.L. Hay et al., "Measuring substrate-independent modulus of thin films," Journal of Materials Research, 26 (2011)), which uses a known film thickness to eliminate the contribution of the substrate material from the measurement of the elastic modulus. The elastic modulus and hardness for the cured films formed from samples C-4 and 10-2 are reported in Table 4. As can be seen from the data, these films had similar elastic modulus and hardness.

Films of each of samples C-4 and 10-1 to 10-4 were spin-coated (1000 rpm, 90 sec.) on 200 mm silicon wafers, baked at 110 °C, and then cured in a belt furnace under $N_2$ using the following programmed temperature sequence: 250 °C - 300 °C - 400 °C (4 zones) - 300 °C - 250 °C, with 7.5 min for each zone. Wafer bowing at varying temperature points was determined for each cured film using a FLX2320 stress measurement tool (KLA-Tencor), which relates film stress (in MPa) to temperature. The slope of each stress-temperature plot represents the contributions from both the modulus of the cured film under examination and the differences in CTE between the substrate wafer and the cured film. While this is not a direct determination of the CTE, the stress-temperature data and film modulus data can be used to compute CTE according to Stoney's equation:

$$\Delta\sigma_f = \Delta\alpha E_f \Delta T = \frac{1}{6}\left(\frac{E_S}{(1-V_S)}\right)\left(\frac{h_S^2}{h_f}\right)\left(\frac{1}{R}\right)$$

where the biaxial elastic modulus of the substrate ($E_s/(1-vs)$), substrate thickness($h_s$), thin film thickness($h_f$) and radius of curvature **($R$)** are known. The CTE for each of the cured films from samples C-4 and 10-1 to 10-4 was calculated, using poly(methylmethacrylate) thin film as a reference material (which has a known modulus of 2.8 GPa and CTE of

68.8 ± 4.1 ppm/°C). The calculated CTE values for each of the samples is also reported in Table 4.

Table 4

| Sample | $M_w$ | CTE (ppm/°C) | Modulus (GPa) | Hardness (Pa) |
|---|---|---|---|---|
| C-4 | 15000 | 65 | 3.1 | 0.22 |
| 10-1 | 20000 | 38 | - | - |
| 10-2 | 32000 | 39 | 3.3 | 0.25 |
| 10-3 | 46000 | 39 | - | - |
| 10-4 | 57000 | 70 | - | - |

Example 11. The general procedure of Example 1 was repeated using the solvent and reaction temperature reported in Table 5. All reaction times were 4 hours. The $M_w$ of the resulting oligomers is also reported in Table 5. Comparative sample C-5 was prepared in propylene glycol methyl ether acetate (PGMEA).

Table 5

| Sample | $M_w$ | Solvent | Temp (°C) |
|---|---|---|---|
| C-5 | 8700 | PGMEA | 147 |
| 11-1 | 19700 | Anisole | 154 |
| 11-2 | 21100 | Tetrahydrofurfuryl acetate | 160 |
| 11-3 | 21400 | Gamma butyrolactone | 160 |
| 11-4 | 21800 | Benzyl propionate | 160 |
| 11-5 | 22600 | Ethoxybenzene | 160 |
| 11-6 | 34000 | p-Propylanisole | 160 |

**Claims**

1. An oligomer comprising as polymerized units a first monomer comprising two cyclopentadienone moieties and a second monomer having the formula

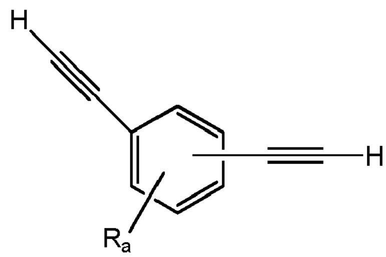

wherein a is the number of R groups and is an integer from 0 to 4; each R is independently chosen from $(C_1\text{-}C_4)$alkyl, halo$(C_1\text{-}C_4)$alkyl, $(C_1\text{-}C_4)$alkoxy, $(C_1\text{-}C_4)$aralkyl, $(C_6\text{-}C_{10})$aryl, or substituted $(C_6\text{-}C_{10})$aryl; wherein the first monomer and the second monomer are present in a mole ratio of from 1:1.001 to 1:1.95; and wherein the oligomer comprises terminal ethynyl moieties.

2. The oligomer of claim 1 wherein the first monomer has the formula

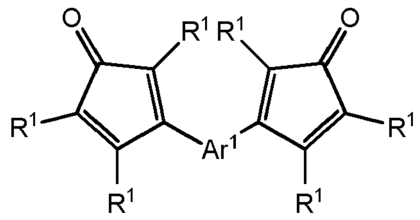

wherein each $R^1$ is independently chosen from H, phenyl, or substituted phenyl; and $Ar^1$ is an aromatic moiety.

**3.** The oligomer of claim 1 wherein the mole ratio of the first monomer to the second monomer is from 1:1.01 to 1:1.75.

**4.** The oligomer of claim 1 wherein the mole ratio of the first monomer to the second monomer is from 1:1.05 to 1:1.5.

**5.** The oligomer of claim 1 having a weight average molecular weight of from 5000 to 60000.

**6.** The oligomer of claim 1 wherein the oligomer is substantially free of polymerized units of monomers having 3 or more ethynyl moieties.

**7.** A composition comprising the oligomer of claim 1 and an organic solvent chosen from benzyl esters of $(C_2-C_6)$alkanecarboxylic acids, dibenzyl esters of $(C_2-C_6)$alkanedicarboxylic acids, tetrahydrofurfuryl esters of $(C_2-C_6)$alkanecarboxylic acids, ditetrahydrofurfuryl esters of $(C_2-C_6)$alkanedicarboxylic acids, phenethyl esters of $(C_2-C_6)$alkanecarboxylic acids, diphenethyl esters of $(C_2-C_6)$alkanedicarboxylic acids, and aromatic ethers.

**8.** The composition of claim 7 wherein the organic solvent is chosen from benzyl acetate, benzyl proprionate, tetrahydrofurfuryl acetate, tetrahydrofurfuryl propionate, tetrahydrofurfuryl butyrate, anisole, methylanisole, dimethylanisole, dimethoxybenzene, ethylanisole, ethoxybenzene, benzyl methyl ether, and benzyl ethyl ether.

**9.** The composition of claim 7 further comprising a water-miscible organic solvent.

**10.** A method of forming a dielectric material layer comprising: disposing a layer of the composition of claim 7 on a substrate surface; removing the organic solvent; and curing the oligomer to form a dielectric material layer.

Europäisches Patentamt
European Patent Office
Office européen des brevets

# EUROPEAN SEARCH REPORT

Application Number
EP 14 19 4650

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DATABASE WPI<br>Week 200120<br>Thomson Scientific, London, GB;<br>AN 2001-198124<br>XP002734399,<br>-& JP 2001 019724 A (JSR CORP)<br>23 January 2001 (2001-01-23)<br>* abstract *<br>* paragraphs [0001], [0033] - [0050], [0059] - [0062]; claims 4-8 *<br>----- | 1-10 | INV.<br>C08G61/10<br>C08G61/12<br>C09D165/02<br>C08L65/02<br>H01L23/14<br>H01L23/498<br>H01L23/532<br>H01B3/30 |
| X | US 7 888 397 B1 (HIBBS MICHAEL [US] ET AL)<br>15 February 2011 (2011-02-15)<br>* column 3, line 56 - column 4, line 25; figure 4; example 3 *<br>----- | 1-10 | |
| X | FUJIMOTO CY H ET AL: "IONOMERIC POLY(PHENYLENE) PREPARED BY DIELS-ALDER POLYMERIZATION: SYNTHESIS AND PHYSICAL PROPERTIES OF A NOVEL POLYELECTROLYTE", MACROMOLECULES, AMERICAN CHEMICAL SOCIETY, US,<br>vol. 38, no. 12, 12 May 2005 (2005-05-12), pages 5010-5016, XP002492133,<br>ISSN: 0024-9297, DOI: 10.1021/MA0482720<br>[retrieved on 2005-05-12]<br>* text sections "Introduction" and "Experimental Section" on pages 5010 - 5012 *<br>----- | 1-3,5-10 | TECHNICAL FIELDS SEARCHED (IPC)<br>C08G<br>C09D<br>C08L<br>H01L<br>H01B |
| X | US 8 110 636 B1 (FUJIMOTO CY H [US] ET AL)<br>7 February 2012 (2012-02-07)<br>* column 4, line 53 - column 7, line 30 *<br>----- | 1-3,5-10 | |

1 The present search report has been drawn up for all claims

| Place of search | Date of completion of the search | Examiner |
|---|---|---|
| Munich | 14 January 2015 | Meiners, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 14 19 4650

This annex lists the patent family members relating to the patent documents cited in the above-mentioned European search report. The members are as contained in the European Patent Office EDP file on
The European Patent Office is in no way liable for these particulars which are merely given for the purpose of information.

14-01-2015

| Patent document cited in search report | Publication date | Patent family member(s) | Publication date |
|---|---|---|---|
| JP 2001019724 A | 23-01-2001 | NONE | |
| US 7888397 B1 | 15-02-2011 | NONE | |
| US 8110636 B1 | 07-02-2012 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 5965679 A
- US 6288188 A
- US 6646081 A
- WO 9710193 A
- WO 2004073824 A
- US 5668210 A


### Non-patent literature cited in the description


- **J.K. STILLE et al.** *Polymer Letters,* 1996, vol. 4, 791-793
- **W.C. OLIVER et al.** Measurement of Hardness and Elastic Modulus by Instrumented indentation: Advances in Understanding and Refinements to Methodology. *Journal of Materials Research,* 2004, 19
- **J.L. HAY et al.** Measuring substrate-independent modulus of thin films. *Journal of Materials Research,* 2011, 26